# EUROPEAN PATENT SPECIFICATION

(11) **EP 4 702 277 B1**
(45) Date of publication and mention of the grant of the patent: **25.11.2026**
(21) Application number: 24719160.4
(22) Date of filing: 12.04.2024
(51) Int. Cl.: H10H 20/851, H10H 20/852, F21K 9/232, F21K 9/64, F21V 9/38, F21Y 115/10

(54) **A LED FILAMENT**
LED-FILAMENT
FILAMENT DE DEL

(30) Priority: 24.04.2023 EP 23169459
(43) Date of publication of application: 04.03.2026
(73) Proprietor: Signify Holding B.V., 5656 AE Eindhoven (NL)
(72) Inventor: VAN BOMMEL, Ties, 5656 AE Eindhoven (NL); HIKMET, Rifat, Ata, Mustafa, 5656 AE Eindhoven (NL)
(74) Representative: Verweij, Petronella Daniëlle
(86) International application number: PCT/EP2024/060070
(87) International publication number: WO 2024/223341

(56) References cited:
- WO-A1-2020/190960
- WO-A1-2020/260197
- WO-A1-2022/268700
- US-A1- 2020 303 355

## Description

### TECHNICAL FIELD

The present invention relates to a light-emitting diode (LED) filament.

### BACKGROUND

Efforts have been made to make solid state-based lighting devices, e.g., light-emitting diode (LED) based lighting devices, mimic or resemble traditional incandescent lighting devices, e.g., with respect to light distribution and/or color temperature. In bulb lighting devices based on LEDs, commonly referred to as "retrofit lamps" since these LED lamps are often designed to have the appearance of a traditional incandescent light bulb and to be mounted in conventional sockets, etc., the light emitting filament wire is replaced with one or more LEDs. Such bulb lighting devices based on LEDs may also be referred to as LED bulbs. A LED bulb may for example comprise one or more so-called LED filaments, wherein each LED filament may include multiple LEDs which may be connected in series to form a light-emitting filament. A LED filament lamp, which may be referred to simply as a LED filament, is hence a LED-based lamp which is designed to resemble a traditional incandescent light bulb with one or more visible filaments for aesthetic and light distribution purposes, but with the high efficiency of LEDs. It is desired to improve the performance, functionality and/or appearance of LED filament lamps.

US2011/149549A1 discloses a LED-filament that includes a partially light-transmissive substrate and blue LED chips mounted on a front face of the substrate. First broad-band green to red photoluminescence materials and a first narrow-band manganese-activated fluoride red photoluminescence material are covering the blue LED chips and the front face of the substrate and second broad-band green to red photoluminescence materials are covering the back face of the substrate. The LED-filament can further include a second narrow-band manganese-activated fluoride red photoluminescence material on the back face of the substrate in an amount that is less than 5 wt. % of a total red photoluminescence material content on the back face of the substrate.

### SUMMARY

For example, there is a desire to increase light emission efficiency of light-emitting diode (LED) filaments. Also, in lighting devices such as LED filaments, suitable wavelength converting material(s), which may be referred to as phosphor(s), may be used to provide light emitted by the LED filament in a desired or required wavelength range.

In view of the above, a concern of the present invention is to provide a LED filament which can be used to provide light having a desired or required wavelength range, and which LED filament has a relatively high light emission efficiency.

To address at least one of this concern and other concerns, a LED filament in accordance with the independent claim is provided. Preferred embodiments are defined by the dependent claims.

The inventors have found that although it in general is not feasible to directly apply organic phosphors onto LEDs for general lighting, application of organic phosphor in LED filaments is feasible in particular configurations. One reason for this is that LEDs in LED filaments may provide light having a (e.g., very) low intensity compared to LEDs for general lighting. Thereby, the organic phosphor may not be exposed to light of a high intensity as on normal LEDs (e.g., LEDs for general lighting), which would lead to degradation of the organic phosphor. Another reason is that because light emitted by a LED filament generally has a very (or extremely) low correlated color temperature (CCT), the type of organic phosphor for which there may be most need for in a LED filament is organic phosphor capable of producing light in a red wavelength range. Such organic phosphor may be referred to as "red organic phosphor". Red organic phosphor is generally (e.g., much) more stable than other types of organic phosphor, e.g., organic phosphor capable of producing light in wavelength ranges other than a red wavelength range. For example, red organic phosphor is generally more stable than organic phosphor capable of producing light in a yellow wavelength range, which may be referred to as "yellow organic phosphor".

According to a first aspect of the present invention, a LED filament is provided. The LED filament is configured to, in operation, emit LED filament light. The LED filament comprises a plurality of LEDs. The plurality of LEDs are configured to, in operation, emit LED light having a peak wavelength (e.g., a dominant peak wavelength) in a blue wavelength range from 420 nm to 490 nm. Operation of each of the plurality of LEDs may be controlled individually. The LED filament comprises an elongated carrier, which comprises a major surface on which the plurality of LEDs are arranged. The LED filament comprises a first wavelength-converting encapsulant. The first wavelength-converting encapsulant is arranged to receive at least part the LED light (and possibly at least some of the LED light after having been converted to be in a different wavelength range than before the conversion). The first wavelength-converting encapsulant comprises a first organic wavelength-converting material configured to at least partly convert the LED light into first organic converted light having a peak wavelength (e.g., a dominant peak wavelength) in a red wavelength range of 580 nm to 680 nm. The LED filament comprises a first enclosing structure, which is at least partly enclosing the plurality of LEDs and at least a portion of the major surface. The first enclosing structure is arranged between the plurality of LEDs and the first wavelength-converting encapsulant and such that the first wavelength-converting encapsulant is spaced apart from the plurality of LEDs. A second wavelength-converting encapsulant is arranged to receive at least part of the LED light. The second wavelength-converting encapsulant comprises at least a first inorganic wavelength-converting material configured to at least partly convert the LED light into first inorganic converted light having a peak wavelength in a green-yellow wavelength range of 510 nm to 570 nm. The first wavelength-converting encapsulant comprises a first matrix polymer material and the second wavelength-converting encapsulant comprises a second matrix polymer material different from the first matrix polymer material.

The LED filament is arranged such that the LED filament light comprises at least some of the LED light, at least some of the first organic converted light and at least some of the first inorganic converted light.

The first wavelength-converting encapsulant may for example be arranged or configured such that the first organic converted light has a dominant peak wavelength in a red wavelength range from 580 nm to 680 nm, or such that the first organic converted light has a peak wavelength (e.g., a dominant peak wavelength) in a yellow wavelength range.

Typically a LED filament is providing LED filament light and comprises a plurality of light emitting diodes (LEDs) arranged in a linear array. Preferably, the LED filament has a length L and a width W, wherein L>5W. The LED filament may be arranged in a straight configuration or in a non-straight configuration such as for example a curved configuration, a 2D/3D spiral or a helix. Preferably, the LEDs are arranged on an elongated carrier like for instance a substrate, that may be rigid (made from e.g. a polymer, glass, quartz, metal or sapphire) or flexible (e.g. made of a polymer or metal e.g. a film or foil).

In case the carrier comprises a first major surface and an opposite second major surface, the LEDs are arranged on at least one of these surfaces. The carrier may be reflective or light transmissive, such as translucent and preferably transparent.

The LED filament may comprise an encapsulant at least partly covering at least part of the plurality of LEDs. The encapsulant may also at least partly cover at least one of the first major or second major surface. The encapsulant may be a polymer material which may be flexible such as for example a silicone. Further, the LEDs may be arranged for emitting LED light e.g. of different colors or spectrums. The encapsulant may comprise a luminescent material that is configured to at least partly convert LED light into converted light. The luminescent material may be a phosphor such as an inorganic phosphor and/or quantum dots or rods.

The LED filament may comprise multiple sub-filaments.

Embodiments of the present invention are based on utilizing organic wavelength-converting material arranged at a distance from a plurality of LEDs, configured to emit blue light, in a LED filament. Thereby, a relatively high light emission efficiency of the LED filament may be achieved, and the LED filament may further have a relatively high color rendering index (CRI) and a relatively long lifetime. According to one or more embodiments of the present invention, the first wavelength-converting encapsulant may be referred to as a first phosphor, or a first organic phosphor, without any loss of generality. An organic phosphor may comprise molecules which are molecularly dissolved in a polymer matrix to provide luminescence. Organic phosphor has an advantage of being capable of providing a relatively high light emission efficiency. However, organic phosphor may have relatively short lifetime due to being (e.g., highly) susceptible for light of relatively high intensity in a blue wavelength range, which may cause relatively fast degradation of the organic phosphor. Due to such degradation, it is not feasible to apply organic phosphor directly onto a LED. Placing the organic phosphor at a relatively small distance from the LED, which may be referred to as organic phosphor vicinity mode, may also not be feasible due to such degradation. However, in contrast to 'normal' LEDs, e.g., LEDs for general lighting, which may provide light having a relatively high intensity, LEDs in LED filaments generally provide light having a lower intensity. Compared to LEDs for general lighting, smaller LEDs are typically used in LED filaments. This is due to that in LED filament applications less light may be needed as compared to LEDs for general lighting. The inventors have found out that in LED filaments, organic phosphor can therefore be used in organic phosphor vicinity mode. Further, LED filaments typically provide extremely warm white light, e.g., having a color temperature of less than 2500 K. This means that a relatively large amount of red phosphor may be needed in the LED filament. As mentioned, red organic phosphor is generally more stable than yellow organic phosphor, and red organic phosphor is therefore suitable for LED filaments. In LED filament applications, only a relatively small amount of light in a green wavelength range may be needed in the light emitted by the LED filament. However, as noted in the foregoing, the first wavelength-converting encapsulant must not necessarily be arranged or configured such that the first converted LED light has a peak wavelength in a red wavelength range, but it could for example instead be arranged or configured such that the first converted LED light has a peak wavelength in a yellow wavelength range.

The LED filament light may be white light. The LED filament light may have a correlated color temperature (CCT) in a range between 1500 K and 6500 K, especially between 1500 K and 2500 K. The LED filament light may have CRI of at least 80, preferably at least 90.

According to one or more embodiments of the present invention, at least 80% (preferably at least 85%, more preferably at least 90%, most preferably at least 95%) of wavelength-converting material in the first wavelength-converting encapsulant may be an organic wavelength-converting material (e.g., an organic phosphor).

The first enclosing structure may comprise an encapsulation which may at least partly cover the plurality of LEDs. The encapsulation may further cover at least a portion of the major surface. The first enclosing structure may comprise a flexible encapsulant. The first enclosing structure may comprise a silicone encapsulant, e.g., cross-linked PDMS (polydimethylsiloxane). The first enclosing structure or encapsulation may comprise silicone, such as, for example, polydimethylsiloxane. The encapsulation may cover at least a part of the major surface on the elongated carrier on which the plurality of LEDs are arranged. Accordingly, the first enclosing structure or the encapsulation may be elongated.

A thickness of the first enclosing structure or encapsulation may be within a range from 2 mm to 6 mm. An obtained effect is improved lifetime of the organic phosphor (because applying an organic phosphor directly on top or too close to the LEDs will result in bleaching), while keeping a filament look (i.e., a slim filament).

A distance between the first wavelength-converting encapsulant and the plurality of LEDs may be within a range from 2 mm to 10 mm. An obtained effect is improved lifetime of the organic phosphor (because applying an organic phosphor directly on top or too close to the LEDs will result in bleaching), while keeping a filament look (i.e., a slim filament).

The first enclosing structure may enclose at least a portion of the major surface and at least a portion of a surface of the elongated carrier opposite to the major surface.

The LED filament may have a thickness that is in a range from 5 mm to 10 mm.

The LED filament comprises a second wavelength-converting encapsulant. The second wavelength-converting encapsulant is arranged to receive at least part of the LED light.

The second wavelength-converting encapsulant may be comprised in the first enclosing structure. For example, the first enclosing structure or the encapsulation may be covered with a luminescent layer, which for example may comprise an organic luminescent material in a polymer, e.g., in a polymer matrix, which for example may comprise poly(methyl methacrylate), polyethylene terephthalate, and/or polycarbonate.

The second wavelength-converting encapsulant comprises at least a first inorganic wavelength-converting material configured to at least partly convert the LED light into first inorganic converted light having a peak wavelength (e.g., a dominant peak wavelength) in a green-yellow wavelength range of 510 nm to 570 nm. The LED filament is arranged such that the LED filament light comprises at least some of the LED light, at least some of the first organic converted light and at least some of the first inorganic converted light.

According to one implementation example, the first wavelength-converting encapsulant is arranged or configured such that the first organic converted light has a peak wavelength in a red wavelength range from 580 nm to 680 nm, and the LED filament is arranged such that the LED filament light comprises white light comprising at least some of the LED light, at least some of the first organic converted light and at least some of the first inorganic converted light, wherein the first organic converted light may be at least 60% of the white light.

According to one or more embodiments of the present invention, at least 80% (preferably at least 85%, more preferably at least 90%, most preferably at least 95%) of wavelength-converting material in the second wavelength-converting encapsulant may be an inorganic wavelength-converting material (e.g., an inorganic phosphor).

The first wavelength-converting encapsulant may comprise a second organic wavelength-converting material configured to at least partly convert the LED light into second organic converted light having a peak wavelength (e.g., a dominant peak wavelength) in a green-yellow wavelength range of 510 nm to 570 nm. The LED filament may be arranged such that the LED filament light comprises at least some of the LED light, at least some of the first organic converted light and at least some of the second organic converted light.

In the context of the present application, by the terms "organic converted light" and "inorganic converted light", it is meant light having been produced by means of organic wavelength-converting material and inorganic wavelength-converting material, respectively.

The second wavelength-converting encapsulant may comprise at least one inorganic wavelength-converting material. In alternative or in addition, the second wavelength-converting encapsulant may comprise at least one organic wavelength-converting material. According to one or more embodiments of the present invention, the second wavelength-converting encapsulant may be referred to as a second phosphor.

The second wavelength-converting encapsulant may be comprised in the first enclosing structure. For example, the encapsulation may comprise the first inorganic wavelength-converting material. Especially, a (first) inorganic wavelength-converting material is highly suitable for this architecture because, compared to a (first and second) organic wavelength-converting material, an inorganic wavelength-converting material is much more stable and is exhibiting a longer lifetime and can thus be directly applied onto the LEDs.

According to one implementation example, the second wavelength-converting encapsulant may comprise a green-yellow organic phosphor, e.g., BASF Lumogen^{®} Yellow F083 and/or green, and the first wavelength-converting encapsulant may comprise a red organic phosphor, e.g., BASF Lumogen^{®} Red F305.

Examples of suitable organic phosphor materials are organic luminescent materials based on perylene derivatives, for example compounds sold under the name Lumogen^{®} by BASF. Examples of suitable compounds include, but are not limited to, Lumogen^{®} Red F305, Lumogen^{®} Orange F240, Lumogen^{®} Yellow F083, and Lumogen^{®} F170.

Examples of inorganic wavelength-converting materials are materials of the type A₃B₅O₁₂:Ce, wherein A in embodiments comprises one or more of Y, La, Gd, Tb and Lu, especially (at least) one or more of Y, Gd, Tb and Lu, and wherein B in embodiments comprises one or more of Al, Ga, In and Sc. Especially, A may comprise one or more of Y, Gd and Lu, such as especially one or more of Y and Lu. Especially, B may comprise one or more of Al and Ga, more especially at least Al, such as essentially entirely Al. Hence, especially suitable luminescent materials are cerium comprising garnet materials. Embodiments of garnets especially include A₃B₅O₁₂ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B comprises aluminum (Al), however, B may also partly comprise gallium (Ga) and/or scandium (Sc) and/or indium (In), especially up to about 20% of Al, more especially up to about 10 % of Al (i.e. the B ions essentially consist of 90 or more mole % of Al and 10 or less mole % of one or more of Ga, Sc and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A.

Further examples of inorganic wavelength-converting materials are materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba.

Further examples of inorganic wavelength-converting materials are materials comprising M₂AX₆ doped with tetravalent manganese, wherein M comprises an alkaline cation, wherein A comprises a tetravalent cation, and wherein X comprises a monovalent anion, at least comprising fluorine. Even more especially, wherein M comprises at least one or more of K and Rb, wherein A comprises one or more of Si and Ti, and wherein X=F. An example of a suitable first luminescent material is e.g. K₂SiF₆:Mn (e.g. 5%) (i.e. K₂Si₍₁₋ₓ₎MnₓF₆, with x=0.05). Here, M is substantially 100% K, A is substantially 100% Si, but with a replacement thereof with 5% Mn (thus effectively 95% Si and 5% Mn), and X is substantially 100% F. In specific embodiments, M is essentially K. Such luminescent material may especially emit in the red, due to the tetravalent manganese. The term "first luminescent material" may also refer to a plurality of different first luminescent materials of the type M₂AX₆ doped with tetravalent manganese, such as e.g. K₂SiF₆:Mn and/or K₂TiF₆:Mn. In embodiments, M comprises potassium and A comprises silicon. Hence, in embodiments the particulate first luminescent material comprises K₂SiF₆ doped with tetravalent manganese. Note that when there are different first luminescent materials, the weight percentage and/or y/x ratios relate to each type of first luminescent material, respectively. Hence, in specific embodiments the first luminescent material may comprise Mn comprising M₂(Si,Ti)X₆, more especially Mn comprising K₂(Si,Ti)F₆, wherein "Si, Ti" refers to one or more of Si and Ti. First luminescent materials may also be selected from the group of K₂[SiF₆]:Mn⁴⁺, Na₂[SiF₆]:Mn⁴⁺, K₂[TiF₆]:Mn⁴⁺, Ba[TiF₆]:Mn⁴⁺, K₂[SnF₆]:Mn⁴⁺, Na₂[TiF₆]:Mn⁴⁺, KRb[TiF₆]:Mn⁴⁺ and K₂[Si_{0.5}Ge_{0.5}F₆]:Mn⁴⁺, though further options may also be possible.

The LED filament may comprise a second enclosing structure, which may at least partly enclose the plurality of LEDs, at least a portion of the major surface, and the first enclosing structure.

The second enclosing structure may be arranged between the first enclosing structure and the first wavelength-converting encapsulant. The second wavelength-converting encapsulant may be comprised in the second enclosing structure.

The first wavelength-converting encapsulant may be comprised in the second enclosing structure.

Each or any of the first enclosing structure and the second enclosing structure may at least in part be formed as a layer.

Each or any of the first enclosing structure and the second enclosing structure may comprise or be constituted by an encapsulation or layer. Possibly, the first enclosing structure may be referred to as a first encapsulation or layer, and the second enclosing structure may be referred to as a second encapsulation or layer.

The first enclosing structure or encapsulation and the second enclosing structure or encapsulation may be made of different materials. The first enclosing structure may comprise silicone, and the second enclosing structure may comprise one or more polymers different from silicone. For example, the first enclosing structure or encapsulation may comprise polydimethylsiloxane, while the second enclosing structure or encapsulation may comprise poly(methyl methacrylate), polyethylene terephthalate, and/or polycarbonate. The second enclosing structure, encapsulation or layer may comprise a foil which may be directly applied on the first enclosing structure, encapsulation or layer. As mentioned, the first wavelength-converting encapsulant may be comprised in the second enclosing structure. The second enclosing structure, encapsulation or layer may comprise a silicone comprising polymer particles for example based on poly(methyl methacrylate), polyethylene terephthalate, and/or polycarbonate, in which the organic phosphor may be molecularly dissolved.

The first wavelength-converting encapsulant comprises a first matrix polymer material. The second wavelength-converting encapsulant comprises a second matrix polymer material different from the first matrix polymer material. The second matrix polymer material may comprise silicone, and the second matrix polymer material may be different from silicone. Suitable matrix polymer materials are, for example, silicone, poly(methyl methacrylate), polyethylene terephthalate, polycarbonate and epoxy resin. Organic wavelength-converting materials are typically more susceptible to degradation under the influence of water and/or oxygen than inorganic wavelength-converting materials. By choosing a different matrix polymer material for an organic wavelength-converting material and an inorganic wavelength-converting material, the matrix polymer material may be selected such that the degradation of the organic wavelength-converting material is reduced, e.g. by selecting a matrix polymer material for the organic wavelength-converting material that has a lower oxygen and/or water diffusivity that the matrix polymer material for the inorganic wavelength-converting material.

The first wavelength-converting encapsulant may fully, or completely, enclose the plurality of LEDs, the elongated carrier and first enclosing structure.

The first wavelength-converting encapsulant may be comprised in a foil. The foil may be glued to or directly applied on the first enclosing structure. By directly applying the foil on the first enclosing structure, it may be meant that the foil is applied on the first enclosing structure without any intermediate components therebetween.

As mentioned, the second wavelength-converting encapsulant may comprise at least one inorganic wavelength-converting material, and the second wavelength-converting encapsulant may be referred to as a second phosphor. Inorganic phosphor may be dispersed in a silicone, e.g., cross-linked polydimethylsiloxane, because such material is stable and can be applied directly onto LEDs. But it may not be possible to use silicone for dissolving organic phosphor directly, and it may be needed to use polymers such as poly(methyl methacrylate) or polyethylene terephthalate (a foil type or configuration), or the organic phosphor may need to be dissolved in a polymer such as poly(methyl methacrylate) or polyethylene terephthalate and subsequently be cut into small pieces and then dispersed in a silicone matrix (which may be referred to as a particle platform approach).

One or both of the first enclosing structure and the second enclosing structure may enclose at least a portion of the major surface and at least a portion of a surface of the elongated carrier opposite to the major surface.

The elongated carrier may be at least in part light-transmissive.

According to a second aspect of the present invention, a LED filament lamp is provided, which comprises one or more LED filaments according to the first aspect of the present invention. The LED filament lamp may comprise a base for electrically and mechanically connecting the LED filament lamp to a socket of a luminaire. The LED filament lamp may comprise an envelope which may be at least partly enclosing the one or more LED filaments.

The elongated carrier may be arranged such that the major surface on which the LEDs are arranged has a reflectivity of at least 85%, for example at least 90% or at least 95%. Possibly, LEDs may be arranged on the major surface of the elongated carrier such that at most 10% of the surface area of the major surface is covered by LEDs.

The elongated carrier may for example be flexible.

The LED filament may be arranged such that the arrangement of at least some components (e.g., the LEDs, the first wavelength-converting encapsulant, the first enclosing structure and/or possibly the second wavelength-converting encapsulant and/or the second enclosing structure) on and/or at the major surface of the elongated carrier is repeated, or mirrored, on a surface of the elongated carrier opposite to the major surface. The elongated carrier may comprise a first major surface and an opposite second major surface.

Each or any of the LEDs may be controllable, e.g., with respect to switching on and switching off the LED. One or more groups of LEDs may be individually controllable, e.g., with respect to switching on and switching off the LEDs of the group(s). The LED filament may comprise a controller. The controller may be configured to control operation of the LEDs. The controller may be configured to control operation of the LEDs at least with respect to switching on and switching off each or any of the LEDs.

In the context of the present application, a LED filament may be providing LED filament light and comprises a plurality of LEDs which may be arranged in a linear array. Preferably, the LED filament has a length L and a width W, wherein L>5W. The LED filament may be arranged in a straight configuration or in a non-straight configuration such as for example a curved configuration, a 2D/3D spiral or a helix. Preferably, the LEDs are arranged on an elongated carrier (such as the elongated carrier as described above) like for instance a substrate, that may be rigid (made from, e.g., a polymer, glass, quartz, metal or sapphire) or flexible (e.g., made of a polymer or metal, e.g., a film or foil).

In case the carrier comprises a first major surface and an opposite second major surface, the LEDs may be arranged on at least one of these surfaces. The carrier may be reflective or light transmissive, such as translucent and preferably transparent.

The LED filament may comprise one or more encapsulants at least partly covering at least part of the plurality of LEDs. The encapsulant(s), which may be considered as an example of the first enclosing structure and possibly the second enclosing structure as described herein, may also at least partly cover at least one of the first major or second major surface. The encapsulant may be a polymer material which may be flexible such as for example a silicone. Further, the LEDs may be arranged for emitting LED light, e.g., of different colors or spectrums. The encapsulant may comprise a luminescent material that is configured to at least partly convert LED light into converted light. The luminescent material may be a phosphor such as an inorganic phosphor and/or quantum dots or rods.

The LED filament may comprise multiple sub-filaments.

Each or any one of the plurality of LEDs may for example include or be constituted by an inorganic LED and/or an organic LED (OLED). Solid state light emitters are relatively cost-efficient light sources since they in general are relatively inexpensive and have a relatively high optical efficiency and a relatively long lifetime. Examples of LEDs include semiconductor, organic, or polymer/polymeric LEDs, optically pumped phosphor coated LEDs, optically pumped nano-crystal LEDs or any other similar devices as would be readily understood by a person skilled in the art. For example, the term LED can encompass a bare LED die arranged in a housing, which may be referred to as a LED package. According to another example, the term LED can encompass a Chip Scale Package (CSP) LED, which may comprise a LED die directly attached to a substrate such as a PCB, and not via a sub-mount. The term LED can for example encompass a laser diode, because a laser diode is a diode which emits light.

Further objects and advantages of the present invention are described in the following by means of exemplifying embodiments. It is noted that the present invention relates to all possible combinations of features recited in the claims. Further features of, and advantages with, the present invention will become apparent when studying the appended claims and the description herein. Those skilled in the art realize that different features of the present invention can be combined to create embodiments other than those described herein.

### BRIEF DESCRIPTION OF THE DRAWINGS

Exemplifying embodiments of the invention will be described below with reference to the accompanying drawings.

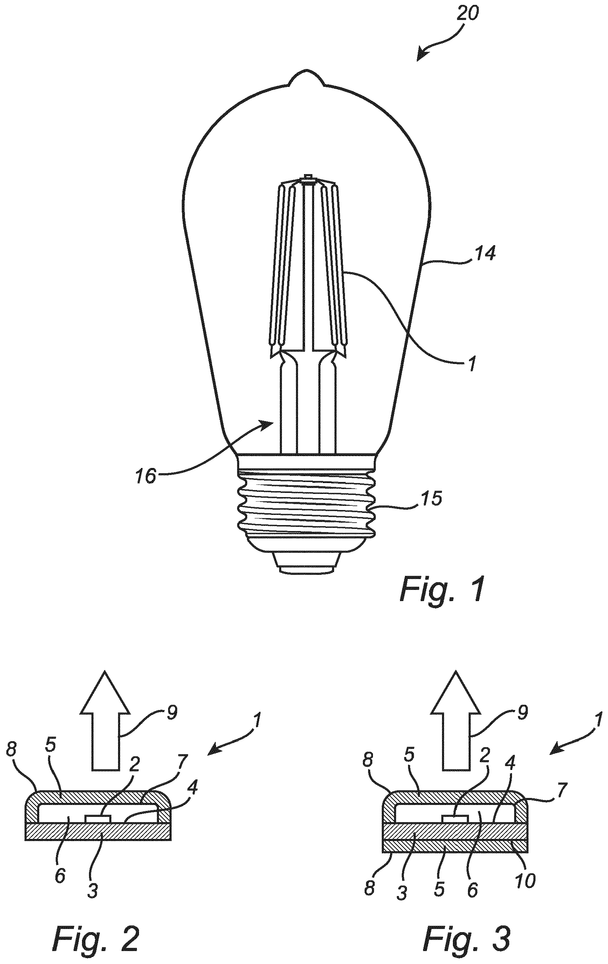

Fig. 1 is a schematic view of a light-emitting diode (LED) filament lamp according to an embodiment of the present invention.

Each of Figs. 2 to 6 is a schematic sectional view of a LED filament according to an embodiment of the present invention.

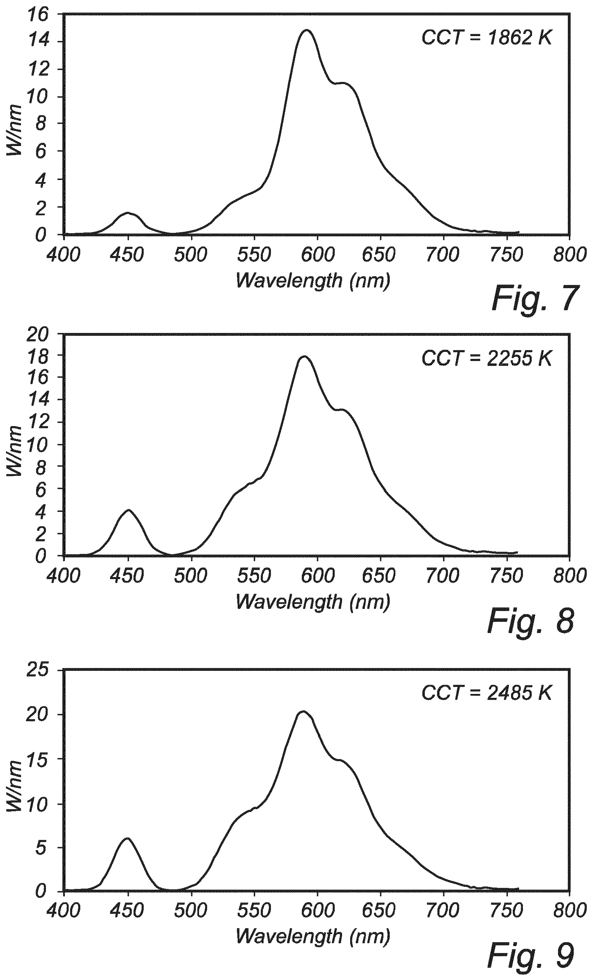

Figs. 7 to 9 are graphs of the spectral flux versus wavelength for LED filament light produced by LED filaments according to embodiments of the present invention.

All the figures are schematic, not necessarily to scale, and generally only show parts which are necessary in order to elucidate embodiments of the present invention, wherein other parts may be omitted or merely suggested.

### DESCRIPTION WITH REFERENCE TO THE DRAWINGS

The present invention will now be described hereinafter with reference to the accompanying drawings, in which exemplifying embodiments of the present invention are shown. The present invention may, however, be embodied in many different forms and should not be construed as limited to the embodiments of the present invention set forth herein; rather, these embodiments of the present invention are provided by way of example so that this disclosure will convey the scope of the invention to those skilled in the art. In the drawings, identical reference numerals denote the same or similar components having a same or similar function, unless specifically stated otherwise.

Figure 1 is a schematic view of a light-emitting diode (LED) filament lamp 20 according to an embodiment of the present invention. The LED filament lamp 20 comprises a plurality of LED filaments 1 according to an embodiment of present invention. Only one of the LED filaments 1 is indicated by a reference numeral in Figure 1. Each of the LED filaments 1 is configured to, in operation, emit LED filament light. As indicated in Figure 1, each of the LED filaments 1 may have an elongated shape. Each of the LED filaments 1 comprises a plurality of LEDs. Embodiments of the LED filaments 1 will be described in greater detail in the following with reference to Figures 2 to 6. It is to be understood that the number of the LED filaments 1 illustrated in Figure 1 is according to an example, and that the LED filament lamp 20 may comprise fewer or more LED filaments 1 than what is illustrated in Figure 1, and that the LED filament lamp 20 could comprise, in principle, any number of LED filaments 1.

The LED filament lamp 20 comprises a base 15, which may be configured to electrically and mechanically connect the LED filament lamp 20 to a luminaire, e.g., to a socket of a luminaire. The LED filament lamp 20 comprises a transmissive envelope 14 (e.g., a light-transmissive envelope) that is coupled to the base 15 and is at least in part enclosing the LED filaments 1. The transmissive envelope 14 may for example be made of glass. The base 15 may include or be constituted by any suitable type of coupler or connector, for example an Edison screw base, a bayonet fitting, or any other type of connection which may be suitable for the particular type of luminaire. The LED filament lamp 20 may comprise one or more controllers, or control units (not shown in Figure 1), which may be configured to control operation of the LEDs of each of the LED filaments 1. The one or more controllers or control units may be configured to control operation of the LEDs of each of the LED filaments 1 at least with respect to switching on and switching off each or any of the LEDs of the respective ones of the LED filaments 1.

As indicated in Figure 1, the LED filaments 1 may be suspended within the transmissive envelope 14 for example by means of some appropriate supporting structure 16, e.g., using any appropriate supporting structure as known in the art.

Figure 2 is a schematic sectional view of a LED filament 1 according to an embodiment of the present invention. As indicated in Figure 1, the LED filament 1 may have an elongated shape. Figure 2 is a cross-sectional view of the LED filament 1 in a plane perpendicular to a longitudinal axis of the LED filament 1. The LED filament 1 is configured to, in operation, emit LED filament light, schematically indicated by the arrow at 9.

The LED filament 1 comprises a plurality of LEDs 2 configured to, in operation, emit LED light having a peak wavelength in a blue wavelength range from 420 nm to 490 nm. The LED filament 1 comprises an elongated carrier 3 comprising a major surface 4 on which the plurality of LEDs are arranged. In accordance with the embodiment of the present invention illustrated in Figure 2, the plurality of LEDs may be arranged in a succession, e.g., in a linear array. Therefore, only one of the LEDs 2 is illustrated in Figure 2. The plurality of LEDs may be arranged in a succession along a direction that may be parallel to a longitudinal axis of the LED filament 1.

The LED filament 1 comprises a first wavelength-converting encapsulant 5, which is arranged to receive part of the LED light. The first wavelength-converting encapsulant 5 comprises a first organic wavelength-converting material configured to at least partly convert the LED light into first organic converted light having a peak wavelength in a red wavelength range of 580 nm to 680 nm.

In accordance with the embodiment of the present invention illustrated in Figure 2, the LED filament 1 comprises a second wavelength-converting encapsulant 6, which is arranged to receive at least part (or a part) of the LED light. The second wavelength-converting encapsulant 6 may comprise at least a first inorganic wavelength-converting material configured to at least partly convert the LED light into first inorganic converted light having a peak wavelength in a green-yellow wavelength range of 510 nm to 570 nm.

The first wavelength-converting encapsulant 5 is arranged to receive at least some of the LED light and/or at least some of the first inorganic converted light.

The LED filament 1 comprises a first enclosing structure 7, which at least partly encloses the plurality of LEDs 2 and at least a portion of the major surface 4. The first enclosing structure 7 is arranged between the plurality of LEDs 2 and the first wavelength-converting encapsulant 5 and such that the first wavelength-converting encapsulant 5 is spaced apart from the plurality of LEDs 2.

In general, the LED filament 1 is arranged such that the LED filament light 9 comprises at least some of the LED light and at least some of the first organic converted light. In accordance with the embodiment of the present invention illustrated in Figure 2, the LED filament 1 is arranged such that the LED filament light 9 comprises at least some of the LED light, at least some of the first organic converted light and at least some of the first inorganic converted light.

In accordance with the embodiment of the present invention illustrated in Figure 2, the LED filament 1 comprises a second enclosing structure 8, which at least partly encloses the plurality of LEDs 2, at least a portion of the major surface 4, and the first enclosing structure 7. In accordance with the embodiment of the present invention illustrated in Figure 2, the first wavelength-converting encapsulant 5 is comprised in the second enclosing structure 8.

Figure 3 is a schematic sectional view of a LED filament 1 according to an embodiment of the present invention. The LED filament 1 illustrated in Figure 3 is similar to the LED filament 1 illustrated in Figure 2, and the same reference numerals in Figures 2 and 3 denote the same or similar components or elements, having the same or similar function. Compared to the LED filament 1 illustrated in Figure 2, according to the LED filament 1 illustrated in Figure 3, the second enclosing structure 8 further encloses at least a portion of a surface 10 of the elongated carrier 3 opposite to the major surface 4. The surface 10 may also be referred to as a major surface of the elongated carrier 3, and the major surfaces 4 and 10 may be referred to as a first major surface 4 and a second major surface 10, respectively, of the elongated carrier 3.

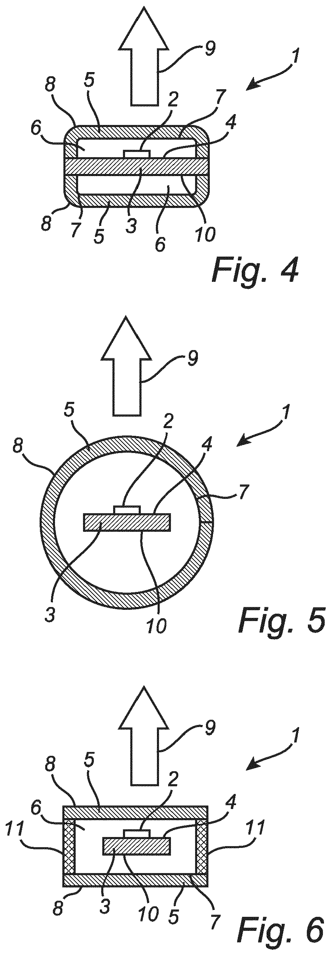

Figure 4 is a schematic sectional view of a LED filament 1 according to an embodiment of the present invention. The LED filament 1 illustrated in Figure 4 is similar to the LED filament 1 illustrated in Figure 3, and the same reference numerals in Figures 3 and 4 denote the same or similar components or elements, having the same or similar function. Compared to the LED filament 1 illustrated in Figure 3, according to the LED filament 1 illustrated in Figure 4, the first enclosing structure 7 further encloses at least a portion of the surface 10 of the elongated carrier 3 opposite to the major surface 4.

Figure 5 is a schematic sectional view of a LED filament 1 according to an embodiment of the present invention. The LED filament 1 illustrated in Figure 5 is similar to the LED filament 1 illustrated in Figure 4, and the same reference numerals in Figures 4 and 5 denote the same or similar components or elements, having the same or similar function. Compared to the LED filament 1 illustrated in Figure 4, according to the LED filament 1 illustrated in Figure 5, the first enclosing structure 7 fully encloses the elongated carrier 3 and the LED(s) 2, at least in a portion of the LED filament 1 including the cross-section illustrated in Figure 5. Further, the second enclosing structure 8 fully encloses the elongated carrier 3, the LED(s) 2 and the first enclosing structure 7, at least in a portion of the LED filament 1 including the cross-section illustrated in Figure 5.

Figure 6 is a schematic sectional view of a LED filament 1 according to an embodiment of the present invention. The LED filament 1 illustrated in Figure 6 is similar to the LED filament 1 illustrated in Figure 5, and the same reference numerals in Figures 5 and 6 denote the same or similar components or elements, having the same or similar function. Compared to the LED filament 1 illustrated in Figure 6, according to the LED filament 1 illustrated in Figure 6, the second enclosing structure 8 does not fully enclose the elongated carrier 3, the LED(s) 2 and the first enclosing structure 7 (at least not in a portion of the LED filament 1 including the cross-section illustrated in Figure 6). The second enclosing structure 8 comprises two parts between which side walls 11 are extending such that the second enclosing structure 8 together with the side walls 11 fully enclose the elongated carrier 3, the LED(s) 2 and the first enclosing structure 7, at least in a portion of the LED filament 1 including the cross-section illustrated in Figure 6. Each or any of the side walls 11 may be reflective and may for example be white. Each or any of the side walls 11 may have a reflectivity of at least 80% or 90%.

Each of Figures 7 to 9 is a graph of the spectral flux (in W / nm) versus wavelength (in nm) for LED filament light produced, or emitted, by a LED filament according to an embodiment of the present invention. The graphs have been obtained by simulations. For each of the embodiments of the present invention pertaining to the respective ones of Figures 7 to 9, the LED filament may be generally configured in accordance with, e.g., the LED filament illustrated in Figure 2. For each of the embodiments of the present invention pertaining to the respective ones of Figures 7 to 9 and with exemplifying reference to Figure 2, the LED filament comprises a plurality of LEDs 2 configured to, in operation, emit LED light having a peak wavelength in a blue wavelength range from 420 nm to 490 nm. The LED filament further comprises a second wavelength-converting encapsulant 6 arranged to receive at least part of the LED light emitted by the plurality of LEDs 2 and comprising at least a first inorganic wavelength-converting material configured to at least partly convert the LED light into first inorganic converted light having a peak wavelength in a green-yellow wavelength range of 510 nm to 570 nm. The LED filament further comprises a first wavelength-converting encapsulant 5 arranged to receive at least some of the LED light and/or at least some of the first inorganic converted light and comprising a first organic wavelength-converting material configured to at least partly convert the LED light into first organic converted light having a peak wavelength in a red wavelength range of 580 nm to 680 nm. The LED filament 1 is arranged such that the LED filament light 9 comprises at least some of the LED light, at least some of the first organic converted light and at least some of the first inorganic converted light. For each of the embodiments of the present invention illustrated in Figures 7 to 9, the first wavelength-converting encapsulant 5 comprises organic red phosphor and the second wavelength-converting encapsulant 6 comprises a green Yttrium Aluminum Garnet (YAG) phosphor, and the plurality of LEDs 2 are configured to, in operation, emit LED light having a peak wavelength at 450 nm.

For the embodiment of the present invention illustrated in Figure 7, the LED filament light has a correlated color temperature (CCT) of 1862 K, and the contributions from the LED light (i.e., blue light), the first organic converted light, and the first inorganic converted light to the LED filament light are about 3%, 69% and 27%, respectively.

For the embodiment of the present invention illustrated in Figure 8, the LED filament light has a correlated color temperature (CCT) of 2255 K, and the contributions from the LED light (i.e., blue light), the first organic converted light, and the first inorganic converted light to the LED filament light are about 6%, 50% and 44%, respectively.

For the embodiment of the present invention illustrated in Figure 9, the LED filament light has a correlated color temperature (CCT) of 2485 K, and the contributions from the LED light (i.e., blue light), the first organic converted light, and the first inorganic converted light to the LED filament light are about 7%, 41% and 52%, respectively.

Preferably, in one or more embodiments of the present invention, the contributions from the LED light (i.e., blue light), the first converted LED light, and the second converted LED light to the LED filament light are in the ranges 2%-8%, 20%-57%, and 35%-78%, respectively.

Preferably, in one or more embodiments of the present invention, the CCT of the LED filament light is in a range 1700 K-2600 K.

Based on the simulations, for a case where the LED light has a CRI that is exceeding 80, the luminous efficacy of the plurality of LEDs (emitting blue light) is 265 lm / W, 267 lm / W, and 268 lm / W, for the cases of the CCT of the LED light being 2700 K, 3000 K, and 3500 K, respectively. For a case where the LED light has a CRI that is exceeding 90, the luminous efficacy of the plurality of LEDs (emitting blue light) is 263 lm / W and 253 lm / W for the cases of the CCT of the LED light being 4000 K and 5000 K, respectively.

In conclusion, a LED filament is disclosed. The LED filament comprises a plurality of LEDs configured to, in operation, emit LED light having a peak wavelength in a blue wavelength range, and a first wavelength-converting encapsulant being arranged to receive at least part of the LED light and comprising a first organic wavelength-converting material configured to at least partly convert the LED light into first organic converted light having a peak wavelength in a red wavelength range of 580 nm to 680 nm. The LED filament is arranged such that the first wavelength-converting encapsulant is spaced apart from the plurality of LEDs. The LED filament is arranged such that the LED filament light emitted by the LED filament in operation comprises at least some of the LED light and at least some of the first organic converted light.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practising the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A light emitting diode, LED, filament (1) configured to, in operation, emit LED filament light (9), the LED filament comprising:
a plurality of LEDs (2) configured to, in operation, emit LED light having a peak wavelength in a blue wavelength range from 420 nm to 490 nm;
an elongated carrier (3) comprising a major surface (4) on which the plurality of LEDs are arranged;
a first wavelength-converting encapsulant (5) being arranged to receive at least part of the LED light, wherein the first wavelength-converting encapsulant comprises a first organic wavelength-converting material configured to at least partly convert the LED light into first organic converted light having a peak wavelength in a red wavelength range of 580 nm to 680 nm;
a first enclosing structure (7) at least partly enclosing the plurality of LEDs and at least a portion of the major surface, and wherein the first enclosing structure is arranged between the plurality of LEDs and the first wavelength-converting encapsulant and such that the first wavelength-converting encapsulant is spaced apart from the plurality of LEDs;
**characterised by**
a second wavelength-converting encapsulant (6) being arranged to receive at least part of the LED light, wherein the second wavelength-converting encapsulant comprises at least a first inorganic wavelength-converting material configured to at least partly convert the LED light into first inorganic converted light having a peak wavelength in a green-yellow wavelength range of 510 nm to 570 nm;
wherein the first wavelength-converting encapsulant (5) comprises a first matrix polymer material and the second wavelength-converting encapsulant (6) comprises a second matrix polymer material different from the first matrix polymer material; and
wherein the LED filament is arranged such that the LED filament light comprises at least some of the LED light, at least some of the first organic converted light and at least some of the first inorganic converted light.

2. A LED filament (1) according to claim 1, wherein the first enclosing structure (7) comprises an encapsulation which at least partly covers the plurality of LEDs and at least a portion of the major surface.

3. A LED filament (1) according to any one of the preceding claims, wherein a thickness of the first enclosing structure (7) is within a range from 2 mm to 6 mm.

4. A LED filament (1) according to any one of the preceding claims, wherein a distance between the first wavelength-converting encapsulant (5) and the plurality of LEDs (2) is within a range from 2 mm to 10 mm.

5. A LED filament (1) according to any one of the preceding claims, wherein the first inorganic wavelength-converting material is of the type A₃B₅O₁₂:Ce, wherein A comprises one or more of Y, La, Gd, Tb and Lu, and wherein B comprises one or more of Al, Ga, In and Sc.

6. A LED filament (1) according to any one of the preceding claims, wherein one or more of the following applies:
(i) the second wavelength-converting encapsulant (6) is comprised in the first enclosing structure (7), and
(ii) the LED filament further comprises a second enclosing structure (8) at least partly enclosing the plurality of LEDs, at least a portion of the major surface and the first enclosing structure, and wherein the second enclosing structure is arranged between the first enclosing structure and the first wavelength-converting encapsulant (5), wherein the second wavelength-converting encapsulant (6) is comprised in the second enclosing structure (8).

7. A LED filament (1) according to any one of the preceding claims, wherein the second matrix polymer material comprises silicone.

8. A LED filament (1) according to any one of the preceding claims 1 - 6, wherein the second matrix polymer material is different from silicone.

9. A LED filament (1) according to any one of the preceding claims, wherein at least 80% of wavelength-converting material in the second wavelength-converting encapsulant is an inorganic wavelength-converting material, and preferably at least 80% of wavelength-converting material in the first wavelength-converting encapsulant is an organic wavelength-converting material.

10. A LED filament (1) according to any one of the preceding claims, wherein the first wavelength-converting encapsulant (5) fully encloses the plurality of LEDs (2), the elongated carrier (3) and first enclosing structure (7).

11. A LED filament (1) according to any one of the preceding claims, wherein the first wavelength-converting encapsulant (5) is comprised in a foil.

12. A LED filament (1) according to claim 11, wherein the foil is glued to or directly applied on the first enclosing structure.

13. A LED filament (1) according to any one of claims 1-12, wherein the first enclosing structure encloses at least a portion of the major surface and at least a portion of a surface (10) of the elongated carrier opposite to the major surface.

14. A LED filament (1) according to any one of claims 1-13, wherein the first wavelength-converting encapsulant comprises a second organic wavelength-converting material configured to at least partly convert the LED light into second organic converted light having a peak wavelength in a green-yellow wavelength range of 510 nm to 570 nm; and wherein the LED filament is arranged such that the LED filament light comprises at least some of the LED light, at least some of the first organic converted light and at least some of the second organic converted light.

15. A LED filament lamp (20) comprising a base (15) for electrically and mechanically connecting the LED filament lamp to a socket of a luminaire and an envelope (14) at least partly enclosing one or more LED filaments (1) according to any one of the preceding claims.

## Patentansprüche

1. Lichtemitterdiodenfilament, LED-Filament (1), das konfiguriert ist, um in Betrieb LED-Filamentlicht (9) zu emittieren, das LED-Filament umfassend:
eine Vielzahl von LEDs (2), die konfiguriert sind, um in Betrieb LED-Licht, das eine Spitzenwellenlänge in einem blauen Wellenlängenbereich von 420 nm bis 490 nm aufweist, zu emittieren;
einen länglichen Träger (3), umfassend eine Hauptoberfläche (4), auf der die Vielzahl von LEDs angeordnet ist;
ein erstes wellenlängenumwandelndes Verkapselungsmittel (5), das angeordnet ist, um mindestens einen Teil des LED-Lichts zu empfangen, wobei das erste wellenlängenumwandelnde Verkapselungsmittel ein erstes organisches wellenlängenumwandelndes Material umfasst, das konfiguriert ist, um das LED-Licht mindestens teilweise in erstes organisches umgewandeltes Licht, das eine Spitzenwellenlänge in einem roten Wellenlängenbereich von 580 nm bis 680 nm aufweist, umzuwandeln;
eine erste umschließende Struktur (7), die die Vielzahl von LEDs und mindestens einen Abschnitt der Hauptoberfläche mindestens teilweise umschließt, und wobei die erste umschließende Struktur zwischen der Vielzahl von LEDs und dem ersten wellenlängenumwandelnden Verkapselungsmittel angeordnet ist und derart, dass das erste wellenlängenumwandelnde Verkapselungsmittel von der Vielzahl von LEDs beabstandet ist;
**gekennzeichnet durch** ein zweites wellenlängenumwandelndes Verkapselungsmittel (6), das angeordnet ist, um mindestens einen Teil des LED-Lichts zu empfangen, wobei das zweite wellenlängenumwandelnde Verkapselungsmittel mindestens ein erstes anorganisches wellenlängenumwandelndes Material umfasst, das konfiguriert ist, um das LED-Licht mindestens teilweise in erstes anorganisches umgewandeltes Licht, das eine Spitzenwellenlänge in einem grün-gelben Wellenlängenbereich von 510 nm bis 570 nm aufweist, umzuwandeln;
wobei das erste wellenlängenumwandelnde Verkapselungsmittel (5) ein erstes Matrixpolymermaterial umfasst und das zweite wellenlängenumwandelnde Verkapselungsmittel (6) ein zweites Matrixpolymermaterial umfasst, das sich von dem ersten Matrixpolymermaterial unterscheidet; und
wobei das LED-Filament derart angeordnet ist, dass das LED-Filamentlicht mindestens einen Anteil des LED-Lichts, mindestens einen Anteil des ersten organischen umgewandelten Lichts
und mindestens einen Anteil des ersten anorganischen umgewandelten Lichts umfasst.

2. LED-Filament (1) nach Anspruch 1, wobei die erste umschließende Struktur (7) eine Verkapselung umfasst, die die Vielzahl von LEDs und mindestens einen Abschnitt der Hauptoberfläche mindestens teilweise abdeckt.

3. LED-Filament (1) nach einem der vorstehenden Ansprüche, wobei eine Dicke der ersten umschließenden Struktur (7) innerhalb eines Bereichs von 2 mm bis 6 mm liegt.

4. LED-Filament (1) nach einem der vorstehenden Ansprüche, wobei ein Abstand zwischen dem ersten wellenlängenumwandelnden Verkapselungsmittel (5) und der Vielzahl von LEDs (2) innerhalb eines Bereichs von 2 mm bis 10 mm liegt.

5. LED-Filament (1) nach einem der vorstehenden Ansprüche, wobei das erste anorganische wellenlängenumwandelnde Material von der Art A₃B₅O₁₂:Ce ist, wobei A eines oder mehrere von Y, La, Gd, Tb und Lu umfasst und wobei B eines oder mehrere von Al, Ga, In und Sc umfasst.

6. LED-Filament (1) nach einem der vorstehenden Ansprüche, wobei eines oder mehrere der Folgenden zutreffen:
(i) das zweite wellenlängenumwandelnde Verkapselungsmittel (6) ist in der ersten umschließenden Struktur (7) umfasst, und
(ii) das LED-Filament umfasst ferner eine zweite umschließende Struktur (8), die mindestens teilweise die Vielzahl von LEDs, mindestens einen Abschnitt der Hauptoberfläche und die erste umschließende Struktur umschließt, und wobei die zweite umschließende Struktur zwischen der ersten umschließenden Struktur und dem ersten wellenlängenumwandelnden Verkapselungsmittel (5) angeordnet ist, wobei das zweite wellenlängenumwandelnde Verkapselungsmittel (6) in der zweiten umschließenden Struktur (8) umfasst ist.

7. LED-Filament (1) nach einem der vorstehenden Ansprüche, wobei das zweite Matrixpolymermaterial Silikon umfasst.

8. LED-Filament (1) nach einem der vorstehenden Ansprüche 1 bis 6, wobei sich das zweite Matrixpolymermaterial von Silikon unterscheidet.

9. LED-Filament (1) nach einem der vorstehenden Ansprüche, wobei mindestens 80 % des wellenlängenumwandelnden Materials in dem zweiten wellenlängenumwandelnden Verkapselungsmittel ein anorganisches wellenlängenumwandelndes Material ist und vorzugsweise mindestens 80 % des wellenlängenumwandelnden Materials in dem ersten wellenlängenumwandelnden Verkapselungsmittel ein organisches wellenlängenumwandelndes Material ist.

10. LED-Filament (1) nach einem der vorstehenden Ansprüche, wobei das erste wellenlängenumwandelnde Verkapselungsmittel (5) die Vielzahl von LEDs (2), den länglichen Träger (3) und die erste umschließende Struktur (7) vollständig umschließt.

11. LED-Filament (1) nach einem der vorstehenden Ansprüche, wobei das erste wellenlängenumwandelnde Verkapselungsmittel (5) in einer Folie umfasst ist.

12. LED-Filament (1) nach Anspruch 11, wobei die Folie auf die erste umschließende Struktur geklebt oder direkt aufgebracht ist.

13. LED-Filament (1) nach einem der Ansprüche 1 bis 12, wobei die erste umschließende Struktur mindestens einen Abschnitt der Hauptoberfläche und mindestens einen Abschnitt einer Oberfläche (10) des länglichen Trägers gegenüber der Hauptoberfläche umschließt.

14. LED-Filament (1) nach einem der Ansprüche 1 bis 13, wobei das erste wellenlängenumwandelnde Verkapselungsmittel ein zweites organisches wellenlängenumwandelndes Material umfasst, das konfiguriert ist, um das LED-Licht mindestens teilweise in zweites organisches umgewandeltes Licht, das eine Spitzenwellenlänge in einem grün-gelben Wellenlängenbereich von 510 nm bis 570 nm aufweist, umzuwandeln; und wobei das LED-Filament derart angeordnet ist, dass das LED-Filamentlicht mindestens einen Anteil des LED-Lichts, mindestens einen Anteil des ersten organischen umgewandelten Lichts und mindestens einen Anteil des zweiten organischen umgewandelten Lichts umfasst.

15. LED-Filamentlampe (20), umfassend eine Basis (15) zum elektrischen und mechanischen Verbinden der LED-Filamentlampe mit einer Fassung einer Leuchte und einen Kolben (14), der mindestens teilweise ein oder mehrere LED-Filamente (1) nach einem der vorstehenden Ansprüche umschließt.

## Revendications

1. Filament à diodes électroluminescentes,DEL, (1) configuré pour, en fonctionnement, émettre une lumière de filament à DEL (9), le filament à DEL comprenant :
une pluralité de DEL (2) configurée pour, en fonctionnement, émettre une lumière de DEL ayant une longueur d'onde de crête dans une gamme de longueurs d'onde bleues allant de 420 nm à 490 nm ;
un support allongé (3) comprenant une surface principale (4) sur laquelle la pluralité de DEL est agencée ;
un premier encapsulant de conversion de longueur d'onde (5) étant conçu pour recevoir au moins une partie de la lumière de DEL, dans lequel le premier encapsulant de conversion de longueur d'onde comprend un premier matériau de conversion de longueur d'onde organique configuré pour convertir au moins partiellement la lumière de DEL en une première lumière convertie organique ayant une longueur d'onde de crête dans une gamme de longueurs d'onde rouges de 580 nm à 680 nm ;
une première structure d'enveloppement (7) enveloppant au moins partiellement la pluralité de DEL et au moins une partie de la surface principale, et dans lequel la première structure d'enveloppement est agencée entre la pluralité de DEL et le premier encapsulant de conversion de longueur d'onde et de manière que le premier encapsulant de conversion de longueur d'onde soit espacé de la pluralité de DEL ;
**caractérisé par** un second encapsulant de conversion de longueur d'onde (6) qui est agencé pour recevoir au moins une partie de la lumière de DEL, dans lequel le second encapsulant de conversion de longueur d'onde comprend au moins un premier matériau de conversion de longueur d'onde inorganique configuré pour convertir au moins partiellement la lumière de DEL en une première lumière convertie inorganique ayant une longueur d'onde de crête dans une gamme de longueurs d'onde vert-jaune de 510 nm à 570 nm ;
dans lequel le premier encapsulant de conversion de longueur d'onde (5) comprend un premier matériau polymère de matrice et le second encapsulant de conversion de longueur d'onde (6) comprend un second matériau polymère de matrice différent du premier matériau polymère de matrice ; et
dans lequel le filament à DEL est agencé de manière que la lumière du filament à DEL comprenne au moins une partie de la lumière de DEL, au moins une partie de la première lumière convertie organique et au moins une partie de la première lumière convertie inorganique.

2. Filament à DEL (1) selon la revendication 1, dans lequel la première structure d'enveloppement (7) comprend une encapsulation qui recouvre au moins partiellement la pluralité de DEL et au moins une partie de la surface principale.

3. Filament à DEL (1) selon l'une quelconque des revendications précédentes, dans lequel une épaisseur de la première structure d'enveloppement (7) est comprise dans une plage allant de 2 mm à 6 mm.

4. Filament à DEL (1) selon l'une quelconque des revendications précédentes, dans lequel une distance entre le premier encapsulant de conversion de longueur d'onde (5) et la pluralité de DEL (2) est comprise dans une plage allant de 2 mm à 10 mm.

5. Filament à DEL (1) selon l'une quelconque des revendications précédentes, dans lequel le premier matériau de conversion de longueur d'onde inorganique est du type A₃B₅O₁₂:Ce, où A comprend l'un ou plusieurs parmi Y, La, Gd, Tb et Lu, et où B comprend l'un ou plusieurs parmi Al, Ga, In et Sc.

6. Filament à DEL (1) selon l'une quelconque des revendications précédentes, dans lequel l'un ou plusieurs parmi ce qui suit s'appliquent :
(i) le second encapsulant de conversion de longueur d'onde (6) est compris dans la première structure d'enveloppement (7), et
(ii) le filament à DEL comprend en outre une seconde structure d'enveloppement (8) enveloppant au moins partiellement la pluralité de DEL, au moins une partie de la surface principale et la première structure d'enveloppement, et dans lequel la seconde structure d'enveloppement est agencée entre la première structure d'enveloppement et le premier encapsulant de conversion de longueur d'onde (5), dans lequel le second encapsulant de conversion de longueur d'onde (6) est compris dans la seconde structure d'enveloppement (8).

7. Filament à DEL (1) selon l'une quelconque des revendications précédentes, dans lequel le second matériau polymère de matrice comprend du silicone.

8. Filament à DEL (1) selon l'une quelconque des revendications précédentes 1 à 6, dans lequel le second matériau polymère de matrice est différent du silicone.

9. Filament à DEL (1) selon l'une quelconque des revendications précédentes, dans lequel au moins 80 % du matériau de conversion de longueur d'onde dans le second encapsulant de conversion de longueur d'onde est un matériau de conversion de longueur d'onde inorganique, et de préférence au moins 80 % du matériau de conversion de longueur d'onde dans le premier encapsulant de conversion de longueur d'onde est un matériau de conversion de longueur d'onde organique.

10. Filament à DEL (1) selon l'une quelconque des revendications précédentes, dans lequel le premier encapsulant de conversion de longueur d'onde (5) enveloppe complètement la pluralité de DEL (2), le support allongé (3) et la première structure d'enveloppement (7).

11. Filament à DEL (1) selon l'une quelconque des revendications précédentes, dans lequel le premier encapsulant de conversion de longueur d'onde (5) est compris dans une feuille.

12. Filament à DEL (1) selon la revendication 11, dans lequel la feuille est collée à la première structure d'enveloppement ou appliquée directement sur celle-ci.

13. Filament à DEL (1) selon l'une quelconque des revendications 1 à 12, dans lequel la première structure d'enveloppement enveloppe au moins une partie de la surface principale et au moins une partie d'une surface (10) du support allongé opposée à la surface principale.

14. Filament à DEL (1) selon l'une quelconque des revendications 1 à 13, dans lequel le premier encapsulant de conversion de longueur d'onde comprend un second matériau de conversion de longueur d'onde organique configuré pour convertir au moins partiellement la lumière de DEL en une seconde lumière convertie organique ayant une longueur d'onde de crête dans une gamme de longueurs d'onde vert-jaune de 510 nm à 570 nm ; et dans lequel le filament à DEL est agencé de manière que la lumière du filament à DEL comprenne au moins une partie de la lumière de DEL, au moins une partie de la première lumière convertie organique et au moins une partie de la seconde lumière convertie organique.

15. Lampe à filament à DEL (20) comprenant une base (15) pour connecter électriquement et mécaniquement la lampe à filament à DEL à une douille d'un luminaire et une enveloppe (14) renfermant au moins partiellement un ou plusieurs filaments à DEL (1) selon l'une quelconque des revendications précédentes.
